# FASCICULE DE BREVET EUROPEEN

(11) **EP 1 516 078 B1**
(45) Date de publication et mention de la délivrance du brevet: **03.01.2007**
(21) Numéro de dépôt: 03760004.6
(22) Date de dépôt: 11.06.2003
(51) Int. Cl.: C30B 11/00, C30B 15/00, C30B 29/12

(54) **PROCEDE DE MANIPULATION D UN CHLORURE OU BROMURE OU IODURE D E TERRE RARE DANS UN CREUSET COMPRENANT DU CARBONE**
VERFAHREN ZUR BEHANDLUNG VON CHLORIDE, BROMIDE UND JODIDE DER SELTENEN ERDEN IN EINEM KOHLSTOFFHALTIGEN TIEGEL
METHOD FOR MANIPULATING A RARE EARTH CHLORIDE OR BROMIDE OR IODIDE IN A CRUCIBLE COMPRISING CARBON

(30) Priorité: 12.06.2002 FR 0207187
(43) Date de publication de la demande: 23.03.2005
(73) Titulaire: Saint-Gobain Cristaux & Detecteurs, 92400 Courbevoie (FR)
(72) Inventeur: ILTIS, Alain, F-77690 Montigny sur Loing (FR); OUSPENSKI, Vladimir, F-77140 SAINT-PIERRE LES NEMOURS (FR)
(74) Mandataire: Colombier, Christian
(86) Numéro de dépôt international: PCT/FR2003/001735
(87) Numéro de publication internationale: WO 2003/106741

(56) Documents cités:
- WO-A-01/60944
- WO-A-01/60945
- DE-A- 4 443 001
- US-A- 3 959 442
- US-A- 4 251 315
- US-A- 5 911 824
- US-A- 6 093 245
- KORCZAK ET AL: "Crystal growth and temperature variation of the lattice parameters in LaF3, CeF3, PrF3 and NdF3" JOURNAL OF CRYSTAL GROWTH., vol. 61, no. 3, 1983, pages 601-605, XP002233142 NORTH-HOLLAND PUBLISHING CO. AMSTERDAM., NL ISSN: 0022-0248 cité dans la demande
- PATENT ABSTRACTS OF JAPAN vol. 016, no. 114 (C-0921), 23 mars 1992 (1992-03-23) & JP 03 285898 A (NIPPON MINING CO LTD), 17 décembre 1991 (1991-12-17)
- BLISTANOV A A ET AL: "Peculiarities of the growth of disordered Na, R-fluorite (R=Y, Ce-Lu) single crystals" JOURNAL OF CRYSTAL GROWTH, NORTH-HOLLAND PUBLISHING CO. AMSTERDAM, NL, vol. 237-239, avril 2002 (2002-04), pages 899-903, XP004356227 ISSN: 0022-0248
- DUFFY S ET AL: "Bridgman growth and laser excitation of LiYF4:Sm3+" JOURNAL OF CRYSTAL GROWTH, NORTH-HOLLAND PUBLISHING CO. AMSTERDAM, NL, vol. 203, no. 3, juin 1999 (1999-06), pages 405-411, XP004363747 ISSN: 0022-0248 cité dans la demande

## Description

Les halogénures de terre rare (dans ce qui suit, on utilise Ln pour désigner une terre rare), du type chlorure, bromure ou iodure, notamment lorsqu'ils sont dopés au cérium, et en particulier LnBr₃ dopé au cérium et LnCl₃ dopé au cérium, présentent des propriétés de scintillation très intéressantes notamment pour des applications en imagerie nucléaire (Positron-Electron-Tomographie dit PET, Gamma caméra, et autre). Pour exploiter ces propriétés, il faut obtenir ces composés sous forme de cristaux (notamment monocristaux) de grandes dimensions transparents dans la région 320-500nm où se situe l'émission du Ce III, en en conservant la valence III (réduite). Par ailleurs, la grande réactivité chimique des halogénures de terres rares limite sévèrement le choix des matériaux utilisables en tant que creusets. Ce type de cristal est habituellement préparé par tirage dans une installation comprenant un creuset chauffé par induction ou rayonnement d'éléments résistifs. La matière première utilisée peut être source d'impuretés conduisant à des points noirs indésirables dans le cristal final.

Les fluorures de terre rare fondent à très haute température, de 200 à 500°C de plus que les autres halogénures, et sont tellement corrosifs vis-à-vis des oxydes comme la silice ainsi que vis-à-vis des métaux précieux (platine) que leur manipulation en vu de la croissance de cristaux ne peut être réalisée qu'en creuset en carbone. Sur ce type de manipulation de fluorures, on peut citer les documents suivants :
JP 03285898,
Blistanov et al, J. Crystal Growth 237-239 (2002) 899-903,
Duffy et al, J. Crystal Growth 203 (1999) 405-411,
US 3959442
Korczak et al, J. crystal growth vol 61 (1983), n°3, (XP-002233142).

Cependant, la manipulation de fluorures en creuset en carbone mène souvent à des points noirs dans le cristal. De plus, pour l'homme du métier, la réaction entre le carbone et le bain fondu est à priori plus faible pour les fluorures que pour les autres halogénures, du fait que les chlorures, bromures et iodures sont beaucoup plus hygroscopiques que les fluorures. En effet, l'eau ou ses dérivés présents dans les premières est connue pour attaquer le graphite avec création de points noirs dans le cristal final. C'est pourquoi, dès que l'on peut utiliser un autre matériau que le carbone, du fait que l'on manipule non plus des fluorures mais des chlorures ou bromures ou iodures, on utilise alors d'autres matériaux comme la silice ou le platine. En effet, l'homme du métier s'attend à observer beaucoup de points noirs dans le cas de la manipulation d'halogénures de terre rare du type chlorure, bromure ou iodure, car il en observe déjà pour la croissance de cristaux de BaF₂ ou LaF₃ (ces deux cristaux se préparent de façon très proches et sont analogues sur le plan de leur préparation). Cependant, la demanderesse a découvert que l'on pouvait utiliser un creuset comprenant du carbone pour manipuler des chlorures ou bromures ou iodures de terres rare avec encore moins d'inconvénient qu'un creuset en silice.

L'invention concerne la manipulation selon la revendication 1, d'une composition comprenant un halogénure de terre rare essentiellement du type chlorure, bromure ou iodure, notamment dans le cadre de la croissance de cristaux à partir de ladite composition, lesdits cristaux étant généralement de formule AₑLn_{f}X_{(3f+e)} dans laquelle Ln représente une ou plusieurs terre rare(s), X représente un ou plusieur(s) atome(s) d'halogène choisi parmi Cl, Br ou 1, et A représente un ou plusieurs alcalin(s) comme K, Li, Na, Rb ou Cs, e et f représentant des valeurs telles que
- e, pouvant être nul, est inférieur où égal à 2f ,
- f est supérieur ou égal à 1.

Les terres rares (sous forme d'halogénures) concernées sont celles de la colonne 3 (selon la nouvelle notation comme mentionné dans le Handbook of Chemistry and Physics 1994-1995, 75^{ème} édition) du tableau périodique des éléments, incluant Sc, Y, La, et les Lanthanides de Ce à Lu. Sont plus particulièrement concernés les halogénures de Y, La, Gd et Lu, notamment dopés au Ce ou Pr (le terme « dopant » se référant ici à une terre rare minoritaire se substituant à une ou plusieurs terres rares majoritaires, les minoritaires et majoritaires étant compris sous le sigle Ln) . Les halogénures de terre rare concernés par la présente demande peuvent être représentés par LnX₃ dans laquelle Ln représente la terre rare et X représente un atome d'halogène lequel peut être Cl, Br ou I.

Les compositions comprenant un halogénure de terre rare plus particulièrement concernées sont notamment les suivantes :
- ALn₂X₇ dans laquelle Ln représente une ou plusieurs terre rare(s), X représente un ou plusieur(s) atome(s) d'halogène choisi parmi CI, Br ou I, A représentant un alcalin comme Rb et Cs,
- LaCl₃ pouvant notamment être dopé par 0,1 à 50 % en poids de CeCl₃,
- LnBr₃ pouvant notamment être dopé par 0,1 à 50 % en poids de CeBr₃,
- LaBr₃ pouvant notamment être dopé par 0,1 à 50 % en poids de CeBr₃,
- GdBr₃ pouvant notamment être dopé par 0,1 à 50 % en poids de CeBr₃,
- LaₓLn₍₁₋ₓ₎X₃ pouvant notamment être dopé par 0,1 à 50 % de CeX₃, x pouvant aller de 0 à 1, Ln étant une terre rare différente de La, X étant un halogène comme précédemment dit,
- LaₓGd₍₁₋ₓ₎Br₃ pouvant notamment être dopé par 0,1 à 50 % de CeBr₃, x pouvant aller de 0 à 1,
- LaₓLu(₁-ₓ)Br₃ pouvant notamment être dopé par 0,1 à 50 % de CeBr₃ , x pouvant aller de 0 à 1,
- Ln'ₓLn"₍₁₋ₓ₎X'_{3(1-y)}X"_{3y} dans laquelle Ln' et Ln" sont deux terres rares différentes du type Ln, X' et X" étant deux halogènes différents du type X, notamment Cl et Br, x pouvant aller de 0 à 1, y pouvant aller de 0 à 1,
- RbGd₂Br₇ pouvant notamment être dopé par 0,1 à 50 % en poids de CeBr₃,
- RbLn₂Cl₇ pouvant notamment être dopé par 0,1 à 50 % en poids de CeCl₃,
- RbLn₂Br₇ pouvant notamment être dopé par 0,1 à 50 % en poids de CeBr₃,
- CsLn₂Cl₇ pouvant notamment être dopé par 0,1 à 50 % en poids de CeCl₃,
- CsLn₂Br₇ pouvant notamment être dopé par 0,1 à 50 % en poids de CeBr₃,
- K₂LaCl₅ pouvant notamment être dopé par 0,1 à 50 % en poids de CeCl₃.

La composition est généralement exempte de fluorure. Tout halogénure de terre rare dans la composition est donc essentiellement du type chlorure, bromure ou iodure (ce qui inclut les halogénures mixte de ce type). Ainsi, l'invention concerne notamment un procédé pour manipuler une composition comprenant LaCl₃ et/ou LaBr₃ et/ou GdBr₃ et/ou LaₓGd₍₁₋ₓ₎Br₃ avec x allant de 0 à 1, et le cas échéant CeCl₃ et/ou CeBr₃. La composition peut également comprendre un halogénure d'ammonium. La composition comprend généralement au moins 10% en poids de terre rare et plus généralement au moins 20% en poids de terre rare. La composition riche en halogénure de terre rare comprend généralement au moins 80% et plus généralement au moins 90% voire au moins 99% en poids d'halogénure de formule AₑLn_{f}X_{(3f+e)} déjà mentionnée.

Un objet de l'invention est notamment d'utiliser un creuset en graphite ou en carbone amorphe et en particulier un creuset graphite revêtu d'un dépôt pyrolytique pour la croissance de cristaux comprenant un halogénure de terre rare, notamment dont la formule est l'une de celles ci-dessus mentionnées. Cette utilisation devra se faire en conditions peu oxydantes, de préférence sous une pression partielle en oxygène + eau inférieure à 10 millibars, de préférence sous vidé ou en présence de gaz neutre comme l'azote ou l'argon.

Pour la croissance de cristaux d'halogénures de terre rare, on utilise habituellement des ampoules scellées en silice (SiO₂) ou des creusets en platine. Cependant, les halogénures de terre rare ont tendance à coller à ces matériaux de sorte que leur extraction du creuset est rendue difficile. Des fractures de l'halogénure de terre rare ou du creuset peuvent en effet se produire si l'on tente d'extraire l'halogénure à froid (état solide). Par ailleurs, si l'on réchauffe superficiellement l'halogénure pour l'extraire, les hautes températures nécessaires (plus de 800°C) se traduisent par une oxydation indésirable, et par ailleurs le choc thermique induit risque de provoquer sa cassure. De plus, le platine est très onéreux. Par ailleurs, les creusets en silice ont une conduction thermique faible mais sont transparents au rayonnement thermique, ce qui complique le contrôle de la température et en conséquence de la croissance cristalline. Afin de bien contrôler les transferts thermiques, un creuset opaque au rayonnement et conducteur thermique est préférable.

Si l'on utilise un creuset en graphite pour la croissance de cristaux de CaF₂ ou BaF₂ ou Nal:TI on observe la présence de petites particules de graphite incluses dans les cristaux réalisés, lesdites petites particules étant très dommageables aux propriétés optiques desdits cristaux en particulier à la transmission dans le proche UV. Ceci montre qu'il est difficile de prévoir a priori l'applicabilité d'un matériau en tant que creuset.

WO 01/60944 et WO 01/60945 enseignent l'utilisation d'ampoules scellées en SiO₂ pour contenir de l'halogénure de terre rare.

Les US5911824 et US6093245 enseignent l'utilisation de creusets en graphite pour la croissance de monocristaux de Nal. Cependant la croissance de tels cristaux de Nal en creuset graphite mène à des cristaux de qualité médiocre pour des applications en tant que cristaux scintillants car contenant des inclusions de graphite.

L'invention concerne l'utilisation d'un matériau comprenant au moins 20 % en poids de carbone pour entrer en contact notamment à une température supérieure à 500°C avec une composition comprenant un halogénure de terre rare, et ce notamment dans le cadre de la croissance d'un monocristal comprenant un halogénure de terre rare. L'invention concerne également un procédé de manipulation d'une composition comprenant un halogénure de terre rare par un matériau comprenant au moins 20 % en poids de carbone, ladite composition venant en contact sous forme fondue avec ledit matériau à une température supérieure à 500°C.

Dans le cadre de la présente demande, on appelle matériau riche en carbone, un matériau opaque contenant au moins 20 % en poids de carbone. Un tel matériau peut par exemple être en graphite, en carbone amorphe (ou carbone vitreux) en graphite revêtu de carbone pyrolytique, en graphite revêtu de carbure de silicium, en graphite revêtu de nitrure de bore (pouvant être pyrolytique).

Le terme manipulation doit être pris dans son sens général puisqu'il recouvre le simple contact entre le matériau et la composition et le simple fait pour le matériau de contenir la composition comprenant l'halogénure comme c'est le cas d'un creuset. Ainsi, l'invention concerne également le procédé utilisant le matériau riche en carbone pour faire partie d'un creuset et venir en contact avec la composition comprenant un halogénure de terre rare. Le matériau peut comprendre d'une part un substrat en graphite et d'autre part un revêtement, ce revêtement pouvant être en carbone pyrolytique ou en carbure de silicium ou en nitrure de bore (pouvant être pyrolytique). Dans le cas de la présence d'un tel revêtement, le matériau riche en carbone entre en contact avec la composition par l'intermédiaire du revêtement Le revêtement sert notamment à boucher la porosité du graphite.

La composition peut être à l'état fondu ou solide, comme cela arrive lors de la croissance d'un monocristal d'halogénure de terre rare. En effet, pour une telle croissance, on fait d'abord fondre une composition comprenant un halogénure de terre rare dans un creuset et l'on procède ensuite à une cristallisation pour faire croître le monocristal. Dans le cadre d'un tel procédé, le creuset est en contact avec une composition comprenant un halogénure de terre rare fondu et avec un monocristal d'halogénure de terre rare.

L'invention résout les problèmes susmentionnés, puisque grâce à l'utilisation d'un matériau riche en carbone comme creuset pour la croissance d'un monocristal comprenant de l'halogénure de terre rare, on constate qu'il est aisé de récupérer le cristal à froid sans avoir à procéder à sa fusion superficielle, ledit cristal étant par ailleurs exempt de points noirs attribuables à une pollution dans sa masse. Ceci n'est pas observé dans le cas du Nal, même à faible vitesse de tirage, c'est-à-dire même à une vitesse de croissance inférieure à 5 mm/h. Par ailleurs, nous constatons de manière surprenante qu'avec l'utilisation d'une même matière première dans le même four à la même vitesse de tirage, une croissance en creuset silice conduit à des points noirs dans la masse, contrairement à une croissance selon l'invention. Sans que la présente explication ne puisse limiter la portée de la présente demande, il est possible que les particules notamment de graphite , pouvant notamment provenir des éléments chauffant en graphite voire de la matière première, soient plus facilement adsorbées par les parois du creuset lorsque celui-ci contient une composition comprenant un halogénure de terre rare.

Pour le cas où le matériau riche en carbone est utilisé comme creuset, notamment en croissance Bridgman, on constate qu'il est aisé de sortir le cristal du creuset, ce qui montre que ledit cristal subit peu de contraintes lors du refroidissement et risque donc peu de se briser. On peut de plus mentionner que les matériaux riches en carbone comme le graphite sont d'un prix abordable et se laissent facilement façonner en toute forme. Par ailleurs, le graphite étant réducteur, pour le cas où du graphite entre effectivement en contact avec la composition, ledit graphite protège le bain contre l'oxydation, ce qui permet dans le cas de produits dopés, de stabiliser la terre rare dopante dans sa valence réduite (exemple : Ce stabilisé sous valence III). Un creuset en un matériau comprenant au moins 20 % en poids de carbone se laisse réutiliser plusieurs fois, c'est-à-dire au moins 5 fois, voire au moins 10 fois, pour venir en contact avec une composition comprenant un halogénure de terre rare, le creuset revenant à la température ambiante entre chacune des fois. L'utilisation d'un tel creuset pour la manipulation d'une composition comprenant un halogénure de terre rare, et notamment pour la croissance d'un monocristal d'halogénure de terre rare à partir d'une composition fondue comprenant un halogénure de terre rare, est donc particulièrement avantageuse. L'invention concerne également l'utilisation du même creuset au moins 5 fois, voire au moins 10 fois pour la réalisation d'un procédé selon l'invention.

Comme matériau comprenant au moins 20 % en poids de carbone, on désigne tout matériau contenant globalement au moins 20 % de carbone, même si le carbone n'est pas réparti de façon homogène dans ledit matériau (par exemple matériau comprenant un substrat en graphite et un revêtement en nitrure de bore). On peut utiliser un matériau dont la surface de contact avec la composition comprenant l'halogénure de Terre rare contient également elle-même au moins 20 % en poids de carbone, par exemple :
- un matériau comprenant un substrat en graphite et un revêtement en carbone pyrolytique,
- un matériau comprenant un substrat en graphite et un revêtement en carbure de silicium,
- un matériau intégralement en graphite (sans revêtement).

De préférence, l'intégralité de l'objet ayant sa surface venant en contact avec la composition comprenant l'halogénure de terre rare, contient également en tout endroit de sa composition au moins 20 % de carbone.

La surface de contact du matériau riche en carbone peut contenir au moins 90 % en poids de carbone. L'intégralité de l'objet ayant sa surface venant en contact avec la composition comprenant l'halogénure de Terre rare carbone peut contenir au moins 90 % en poids de carbone.

Le matériau riche en carbone peut par exemple être intégralement en graphite. De préférence, Il peut également s'agir de graphite revêtu d'une couche de carbone pyrolytique, ladite couche étant destinée à venir en contact avec la composition comprenant l'halogénure de terre rare, en raison de l'état de surface lisse et peu poreux conféré par ladite couche. II peut également s'agir de graphite revêtu d'une couche de carbure de silicium, ladite couche étant destinée à venir en contact avec la composition comprenant l'halogénure de terre rare.

Dans le cas de l'usage d'un graphite non revêtu, on préfère utiliser un graphite le plus dense possible, c'est-à-dire ayant la porosité ouverte la plus faible possible, par exemple une porosité ouverte inférieure à 10 % en volume. On préfère l'utiliser pour venir en contact avec la composition comprenant l'halogénure de terre rare, sous azote ou sous vide.

Le contact dans le cadre du procédé selon l'invention peut avoir lieu entre 20°C et 1000°C. L'invention présente plus particulièrement un intérêt pour les températures comprises entre 500°C et 1000°C, et notamment lorsque la composition comprenant un halogénure de terre rare est à l'état fondu.

La croissance de ce cristal peut être réalisée selon les techniques connues comme les croissances dites Bridgman, ou Kyropoulos ou Czochralski ou la croissance par la méthode de déplacement du gradient (« gradient freeze method » en anglais). De préférence, le cristal est tiré avec une vitesse de croissance contrôlée inférieure à 5 mm/h. Les avantages inhérents à l'invention sont particulièrement utiles en croissance Bridgman. Le tirage du cristal peut être réalisé dans une installation classique, c'est-à-dire dans laquelle le creuset est chauffé par des éléments chauffants en graphite. En effet, même si ces éléments chauffants en graphite représentent aussi un facteur possible de contamination des cristaux, il semble que le creuset utilisé dans le cadre de l'invention joue un rôle d'attraction des particules de graphite. Ainsi l'invention concerne également un procédé dans lequel le matériau opaque, notamment du type creuset, est chauffé par des éléments chauffants en graphite.

### Exemple 1 : LaCl₃ anhydre

Dans une charge de 500 g de LaCl₃ anhydre sous forme d'une poudre de granulométrie moyenne d'environ 500 µm, on incorpore 50 g de CeCl₃. L'ensemble est chargé dans un four en graphite (éléments chauffants en graphite). On met sous vide secondaire (pression inférieure à 1.10⁻² Pa (1.10⁻⁴ millibar)) jusqu'à 300°C puis on passe sous balayage d'azote. Le produit est fondu dans un creuset en graphite. On effectue la croissance en Bridgman à une vitesse de tirage comprise entre 1 et 3 mm/h. Le cristal obtenu est clair (sans points noirs). Le cristal ne colle pas au creuset.

### Exemple 2 : LaBr₃

Dans une charge de 500 g de LaBr₃ anhydre sous forme d'une poudre de granulométrie moyenne d'environ 500 µm, on incorpore 15 g de NH₄Br. L'ensemble est chargé dans un four en graphite. On met sous vide jusqu'à 170°C puis on passe sous balayage d'azote. Le produit est fondu dans un creuset en graphite. On effectue la croissance en Bridgman. Le cristal obtenu est clair (sans points noirs). Le cristal ne colle pas au creuset.

### Exemple 3 (comparatif): LaCl₃ /Creuset en silice

On met 50 g de LaCl₃ anhydre sous forme d'une poudre dans un creuset en silice que l'on place dans un four étanche. On purge sous vide puis on met sous balayage d'azote. La température est augmentée jusqu'à fusion totale de la charge (900°C environ). Après refroidissement les cristaux de LaCl₃ et le creuset en Silice sont collés et l'ensemble est fracturé.

### Exemple 4 (comparatif): LaCl₃/ Creuset en platine:

On met 40 g de LaCl₃ anhydre sous forme d'une poudre dans un creuset en platine que l'on place dans un four étanche. On purge sous vide puis on met sous balayage d'azote. La température est augmentée jusqu'à fusion totale de la charge (i.e. : 900°C environ). Après refroidissement les cristaux de LaCl₃ et le creuset en platine sont collés. Il n'est pas possible de sortir les cristaux sans fracturation à froid.

### Exemple 5 (comparatif) : BaF₂/ Creuset graphite sous vide

Une charge de 1000 g de BaF₂ contenant 800 ppm en poids environ d'oxygène, est chargée dans un four en graphite. On met sous vide secondaire jusqu'à 1360°C jusqu'à la fusion de la charge. Le produit est fondu dans un creuset en graphite. On effectue la croissance en Bridgman. Le cristal obtenu est clair, contient des points noirs et des bulles de gaz. On observe de nombreux points noirs sur le talon du cristal. Le cristal colle légèrement au creuset, ce qui se traduit par la présence de traces noires sur les surfaces du cristal en contact avec le graphite. La transmission de ce cristal est fortement détériorée dans l'ultraviolet .

### Exemple 6 : LaCl₃ / Creuset graphite revêtu de C Pyrolytique

Dans une charge de 504 g de LaCl₃ anhydre sous forme d'une poudre on incorpore 55 g de CeCl₃ anhydre. L'ensemble est chargé dans un four en graphite. On met sous vide secondaire (pression inférieure à 1.10⁻² Pa (1.10⁻⁴ millibar)) jusqu'à 300°C puis on passe sous balayage d'azote. Le produit est fondu dans un creuset en graphite revêtu d'un dépôt en Carbone pyrolitique. On effectue la croissance en Bridgman. Le monocristal obtenu est clair sans points noirs et ne colle pas au creuset Sous excitation au rayonnement gamma à 622 keV (¹³⁷Cs), l'intensité lumineuse émise est 118% de celle d'un cristal de Nal :Tl (cristal scintillateur de référence). Ceci est le reflet des bonnes propriétés cristallines de l'halogénure de lanthane, en particulier du point de vue de la stabilisation du cérium (l'ion actif pour la scintillation) en valence III.

### Exemple 7: LaBr₃ / Creuset graphite revêtu de C Pyrolytique

Dans une charge de 911 g de LaBr₃ anhydre on incorpore 0,5% en masse de CeBr₃. L'ensemble est chargé dans un four en graphite. On met sous vide jusqu'à 600°C puis on passe sous balayage d'azote. Le produit est fondu à 820°C environ dans un creuset en graphite revêtu de carbone pyrolitique. On effectue la croissance en Bridgman. Le cristal obtenu est exempt de points noirs et ne colle pas au creuset.

### Exemple 8 (comparatif): LaBr₃ / Creuset Silice

Dans une charge de 743 g de LaBr₃ anhydre (issue du même lot que pour l'exemple 7), on incorpore 0,5% en masse de CeBr₃. La matière est identique à celle de l'essai précédent. L'ensemble est chargé dans un four en graphite. On met sous vide jusqu'à 820°C. Le produit est fondu à 820°C environ dans un creuset en silice transparente. On effectue la croissance en Bridgman. Le cristal obtenu contient de nombreux points noirs (contrairement à l'exemple précédent) en zone centrale. L'interface avec le creuset est fortement fracturé.

### Exemple 9 : LaCl₃ / Creuset en graphite revêtu de BN Pyrolytique

On met 50 g de LaCl₃ anhydre sous forme d'une poudre dans un creuset en graphite revêtu de BN pyrolytique que l'on place dans un four étanche. On purge sous vide puis on met sous balayage d'azote. La température est augmentée jusqu'à fusion totale de la charge (900°C environ). Le cristal ne colle pas au creuset. Après refroidissement on sort aisément le bloc fondu, exempt de points noirs du creuset.

### Exemple 10 : LaBr₃ / Creuset en graphite revêtu de BN Pyrolytique

On met 50 g de LaBr₃ anhydre sous forme d'une poudre dans un creuset creuset en graphite revêtu de BN pyrolytique que l'on place dans un four étanche. On purge sous vide puis on met sous balayage d'azote. La température est augmentée jusqu'à fusion totale de la charge (900°C environ). Après refroidissement on sort aisément le bloc fondu, exempt de points noirs du creuset. Le cristal ne colle pas au creuset.

### Exemple 11 (comparatif): Nal / creuset graphite

Une charge de 100 kg de Nal dopé par 1000 ppm en poids d'iodure de Thalium est chargée dans un creuset en graphite revêtu d'un dépot de carbone pyrolitique. Ce creuset est ensuite chargé dans un four Bridgman (ou l'on utilise habituellement des creusets en platine) et subit un cycle standard de croissance Bridgman Nal. Le recuit du cristal s'effectue in situ. Le cristal obtenu se démoule aisément du creuset à froid. La fin de cristallisation (appelée talon du cristal) est grise et contient des traces de carbone. Le cristal présente des nuages d'inclusions et la résolution en énergie sur des pièces de deux pouces (« inch » en anglais) est supérieure à 8,5 % à 622 kev, ce qui est insuffisant pour un cristal de Nal usuel. Les propriétés de scintillation de ce cristal (rendement lumineux par photon gamma et résolution en énergie) sont notablement dégradées par rapport à un cristal obtenu dans un creuset en platine avec la même matière première.

### Exemple 12 : LaCl₃ / Creuset graphite. Croissance de type Kyropoulos

Dans une charge de 1504 g de LaCl₃ anhydre sous forme d'une poudre on incorpore 155 g de CeCl₃ anhydre. L'ensemble est chargé dans un four en graphite. On met sous vide (pression inférieure à 1.10² Pa (1.0 millibar)) jusqu'à 300°C puis on passe sous balayage d'azote. Le produit est fondu dans un creuset en graphite. On effectue la croissance en Kyropoulos (en trempant dans le bain fondu un germe de LaCl₃). Le cristal obtenu est clair sans points noirs. Le résidu du bain fondu ne colle pas au creuset , ce qui permet un nettoyage aisé du creuset.

## Revendications

1. Procédé de manipulation par un matériau d'une composition comprenant au moins 80% en poids d'un halogénure de terre rare de formule AₑLn_{f}X(_{3f+e}) dans laquelle Ln représente une ou plusieurs terre rare(s), X représente un ou plusieur(s) atome(s) d'halogène choisi parmi CI, Br ou 1, A représente un ou plusieurs alcalin(s) choisi parmi K, Li, Na, Rb ou Cs, e et f représentant des valeurs telles que
- e, pouvant être nul, est inférieur où égal à 2f ,
- f est supérieur ou égal à 1,
**caractérisé en ce que** ledit matériau comprend au moins 20 % en poids de carbone, la surface de contact dudit matériau avec ladite composition comprenant au moins 20% en poids de carbone, ladite composition venant en contact avec ledit matériau à l'état fondu à une température supérieure à 500°C.

2. Procédé selon la revendication précédente **caractérisé en ce que** le matériau fait partie d'un creuset.

3. Procédé selon l'une des revendications précédentes **caractérisé en ce que** le matériau comprend du graphite ou du carbone amorphe.

4. Procédé selon la revendication précédente **caractérisé en ce que** le matériau comprend un substrat en graphite et un revêtement destiné à venir en contact avec la composition comprenant l'halogénure de terre rare.

5. Procédé selon la revendication précédente **caractérisé en ce que** le revêtement est en carbone pyrolytique.

6. Procédé selon la revendication 4 **caractérisé en ce que** le revêtement est en carbure de silicium.

7. Procédé selon la revendication 3 **caractérisé en ce que** le matériau est intégralement en graphite ou en carbone amorphe.

8. Procédé selon l'une des revendications précédentes **caractérisé en ce que** le contact a lieu entre 500°C et 1000°C.

9. Procédé selon l'une des revendications précédentes **caractérisé en ce que** la composition comprend au moins 10% en poids de terre rare.

10. Procédé selon la revendication précédente **caractérisé en ce que** la composition comprend au moins 20% en poids de terre rare.

11. Procédé selon l'une des revendications précédentes **caractérisé en ce que** la manipulation est réalisée sous une pression partielle en oxygène + eau inférieure à 1.10³ Pa (10 millibars).

12. Procédé selon l'une des revendications précédentes **caractérisé en ce que** la manipulation entre dans le cadre de la croissance à partir de la composition, d'un monocristal comprenant un halogénure de terre rare.

13. Procédé selon la revendication précédente, **caractérisé en ce que** la croissance est réalisée avec une vitesse de croissance inférieure à 5 mm/h.

14. Procédé selon l'une des deux revendications précédentes **caractérisé en ce que** la croissance est du type Bridgman.

15. Procédé selon l'une des revendications 12 ou 13 **caractérisé en ce que** la croissance est du type Kyropoulos ou Czochralski.

16. Procédé selon l'une des quatre revendications précédentes **caractérisé en ce que** le monocristal est de formule AₑLn_{f}X_{(3f+e)} dans laquelle Ln représente une ou plusieurs terre rare(s), X représente un ou plusieur(s) atome(s) d'halogène choisi parmi CI, Br ou I, A représente un ou plusieurs alcalin(s) choisi parmi K, Li, Na, Rb ou Cs, e et f représentant des valeurs telles que
- e, pouvant être nul, est inférieur où égal à 2f ,
- f est supérieur ou égal à 1.

17. Procédé selon la revendication précédente **caractérisé en ce que** le monocristal est de formule ALn₂X₇ dans laquelle Ln représente une ou plusieurs terre rare(s), X représente un ou plusieur(s) atome(s) d'halogène choisi parmi CI, Br ou I, A représentant Rb ou Cs.

18. Procédé selon la revendication 16 **caractérisé en ce que** la composition comprend LaCl₃ et/ou LaBr₃ et/ou GdBr₃ et/ou LaₓGd₍₁₋ₓ₎Br₃ avec x allant de 0 à 1.

19. Procédé selon la revendication précédente **caractérisé en ce que** la composition comprend également CeCl₃ et/ou CeBr₃.

20. Procédé selon l'une des revendications précédentes **caractérisé en ce que** le matériau est chauffé par des éléments en graphite.

21. Procédé de l'une des revendications précédentes utilisé avec le même creuset, au moins 5 fois, le creuset revenant à la température ambiante entre chacune des fois.

22. Procédé selon la revendication précédente avec le même creuset, au moins 10 fois, le creuset revenant à la température ambiante entre chacune des fois.

## Claims

1. A method of handling a composition comprising at least 80% by weight of a rare-earth halide of formula AₑLn_{f}X_{(3f+e)} in which Ln represents one or more rare earths, X represents one or more halogen atoms chosen from Cl, Br and I, and A represents one or more alkali metals chosen from K, Li, Na, Rb and Cs, e and f representing values such that:
- e, which may be zero, is less than or equal to 2f,
- f is greater than or equal to 1,
with a material **characterized in that** said material comprises at least 20% carbon by weight, the surface of said material that is in contact with said composition comprising at least 20% carbon by weight, said composition coming into contact with said material in the molten state at a temperature above 500°C.

2. The method as claimed in the preceding claim, **characterized in that** the material forms part of a crucible.

3. The method as claimed in either of the preceding claims, **characterized in that** the material comprises graphite or amorphous carbon.

4. The method as claimed in the preceding claim, **characterized in that** the material comprises a graphite substrate and a lining intended to come into contact with the composition comprising the rare-earth halide.

5. The method as claimed in the preceding claim, **characterized in that** the lining is made of pyrolytic carbon.

6. The method as claimed in claim 4, **characterized in that** the lining is made of silicon carbide.

7. The method as claimed in claim 3, **characterized in that** the material is entirely made of graphite or of amorphous carbon.

8. The method as claimed in one of the preceding claims, **characterized in that** contact takes place between 500°C and 1000°C.

9. The method as claimed in one of the preceding claims, **characterized in that** the composition comprises at least 10% by weight of rare earth.

10. The method as claimed in the preceding claim, **characterized in that** the composition comprises at least 20% by weight of rare earth.

11. The method as claimed in one of the preceding claims, **characterized in that** the handling is carried out under an oxygen/water partial pressure of less than 1x10³ Pa (10 millibars).

12. The method as claimed in one of the preceding claims, **characterized in that** the handling takes place within the context of the growth, from the composition, of a single crystal comprising a rare-earth halide.

13. The method as claimed in the preceding claim, **characterized in that** the growth is carried out with a growth rate of less than 5 mm/h.

14. The method as claimed in either of the two preceding claims, **characterized in that** the growth is of the Bridgeman type.

15. The method as claimed in one of claims 12 and 13, **characterized in that** the growth is of the Kyropoulos or Czochralski type.

16. The method as claimed in one of the four preceding claims, **characterized in that** the single crystal is of formula AₑLn_{f}X_{(3f+e)} in which Ln represents one or more rare earths, X represents one or more halogen atoms chosen from Cl, Br and I, and A represents one or more alkali metals chosen from K, Li, Na, Rb and Cs, e and f representing values such that:
- e, which may be zero, is less than or equal to 2f,
- f is greater than or equal to 1.

17. The method as claimed in the preceding claim, **characterized in that** the single crystal is of formula ALn₂X₇ in which Ln represents one or more rare earths and X represents one or more halogen atoms, chosen from Cl, Br and I, A representing Rb or Cs.

18. The method as claimed in claim 16, **characterized in that** the composition comprises LaCl₃ and/or LaBr₃ and/or GdBr₃ and/or LaₓGd₍₁₋ₓ₎Br₃ with x ranging from 0 to 1.

19. The method as claimed in the preceding claim, **characterized in that** the composition also comprises CeCl₃ and/or CeBr₃.

20. The method as claimed in one of the preceding claims, **characterized in that** the opaque material is heated by graphite elements.

21. The method as claimed in one of the preceding claims, used with the same crucible at least five times, the crucible returning to ambient temperature between each time.

22. The method as claimed in the preceding claim, used with the same crucible at least ten times, the crucible returning to ambient temperature between each time.

## Patentansprüche

1. Verfahren zur Behandlung einer Zusammensetzung, die mindestens 80 Gew.-% eines Seltenerdmetallhalogenids mit der Formel AₑLn_{f}X_{(3f+e)} umfasst, in welcher Ln ein oder mehrere Seltenerdmetalle, X ein oder mehrere Halogenatome, die aus Cl, Br oder I ausgewählt sind, und A ein oder mehrere Alkalimetallatome, die aus K, Li, Na, Rb oder Cs ausgewählt sind, bedeutet und e und f solche Werte bedeuten, dass
- e Null sein kann und kleiner als oder gleich 2f ist und
- f größer als oder gleich 1 ist,
in einem Material, **dadurch gekennzeichnet, dass** das Material mindestens 20 Gew.-% Kohlenstoff umfasst, die Berührungsfläche des Materials mit der Zusammensetzung wenigstens 20 Gew.-% Kohlenstoff enthält und die Zusammensetzung im geschmolzenen Zustand mit diesem Material bei einer Temperatur von über 500 °C in Berührung kommt.

2. Verfahren nach dem vorhergehenden Anspruch, **dadurch gekennzeichnet, dass** das Material Bestandteil eines Tiegels ist.

3. Verfahren nach einem der vorhergehenden Ansprüche, **dadurch gekennzeichnet, dass** das Material Graphit oder amorphen Kohlenstoff umfasst.

4. Verfahren nach dem vorhergehenden Anspruch, **dadurch gekennzeichnet, dass** das Material ein aus Graphit bestehendes Substrat und eine Beschichtung umfasst, die vorgesehen ist, mit der das Seltenerdmetallhalogenid umfassenden Zusammensetzung in Berührung zu kommen.

5. Verfahren nach dem vorhergehenden Anspruch, **dadurch gekennzeichnet, dass** die Beschichtung aus Pyrokohlenstoff besteht.

6. Verfahren nach Anspruch 4, **dadurch gekennzeichnet, dass** die Beschichtung aus Siliciumcarbid besteht.

7. Verfahren nach Anspruch 3, **dadurch gekennzeichnet, dass** das Material integral aus Graphit oder amorphem Kohlenstoff besteht.

8. Verfahren nach einem der vorhergehenden Ansprüche, **dadurch gekennzeichnet, dass** die Berührung zwischen 500 und 1000 °C stattfindet.

9. Verfahren nach einem der vorhergehenden Ansprüche, **dadurch gekennzeichnet, dass** die Zusammensetzung mindestens 10 Gew.-% Seltenerdmetall umfasst.

10. Verfahren nach dem vorhergehenden Anspruch, **dadurch gekennzeichnet, dass** die Zusammensetzung mindestens 20 Gew.-% Seltenerdmetall umfasst.

11. Verfahren nach einem der vorhergehenden Ansprüche, **dadurch gekennzeichnet, dass** die Behandlung bei einem Partialdruck von Sauerstoff + Wasser von unter 1·10³ Pa (10 millibar) durchgeführt wird.

12. Verfahren nach einem der vorhergehenden Ansprüche, **dadurch gekennzeichnet, dass** die Behandlung im Rahmen des Wachstums eines ein Seltenerdmetallhalogenid umfassenden Einkristalls ausgehend von der Zusammensetzung stattfindet.

13. Verfahren nach dem vorhergehenden Anspruch, **dadurch gekennzeichnet, dass** das Kristallwachstum mit einer Wachstumsgeschwindigkeit von unter 5 mm/h stattfindet.

14. Verfahren nach einem der zwei vorhergehenden Ansprüche, **dadurch gekennzeichnet, dass** das Kristallwachstum vom Typ Bridgman ist.

15. Verfahren nach Anspruch 12 oder 13, **dadurch gekennzeichnet, dass** das Kristallwachstum vom Typ Kyropoulos oder Czochralski ist.

16. Verfahren nach einem der vier vorhergehenden Ansprüche, **dadurch gekennzeichnet, dass** der Einkristall die Formel AₑLn_{f}X_{(3f+e)} hat, in welcher Ln ein oder mehrere Seltenerdmetalle, X ein oder mehrere Halogenatome, die aus Cl, Br oder 1 ausgewählt sind, und A ein oder mehrere Alkalimetallatome, die aus K, Li, Na, Rb oder Cs ausgewählt sind, bedeutet und e und f solche Werte bedeuten, dass
- e Null sein kann und kleiner als oder gleich 2f ist und
- f größer als oder gleich 1 ist.

17. Verfahren nach dem vorhergehenden Anspruch, **dadurch gekennzeichnet, dass** der Einkristall die Formel ALn₂X₇ hat, in welcher Ln ein oder mehrere Seltenerdmetalle, X ein oder mehrere Halogenatome, die aus Cl, Br oder I ausgewählt sind, und A Rb oder Cs bedeutet.

18. Verfahren nach Anspruch 16, **dadurch gekennzeichnet, dass** die Zusammensetzung LaCl₃ und/oder LaBr₃ und/oder GdBr₃ und/oder LaₓGd₍₁₋ₓ₎Br₃, wobei x 0 bis 1 bedeutet, umfasst.

19. Verfahren nach dem vorhergehenden Anspruch, **dadurch gekennzeichnet, dass** die Zusammensetzung auch CeCl₃ und/oder CeBr₃ umfasst.

20. Verfahren nach einem der vorhergehenden Ansprüche, **dadurch gekennzeichnet, dass** das Material von Graphitelementen erhitzt wird.

21. Verfahren nach einem der vorhergehenden Ansprüche, in welchem ein und derselbe Tiegel mindestens 5 Mal verwendet wird, wobei er sich zwischen den jeweiligen Malen wieder auf Umgebungstemperatur abkühlt.

22. Verfahren nach dem vorhergehenden Anspruch mit mindestens 10 Mal ein und demselben Tiegel, der sich zwischen den jeweiligen Malen wieder auf Umgebungstemperatur abkühlt.
